(19) Europäisches Patentamt / European Patent Office / Office européen des brevets

(11) **EP 2 051 372 A2**

(12) **EUROPÄISCHE PATENTANMELDUNG**

(43) Veröffentlichungstag:
**22.04.2009 Patentblatt 2009/17**

(51) Int Cl.:
*H03F 3/00* (2006.01)     *G05B 6/02* (2006.01)

(21) Anmeldenummer: **09151770.6**

(22) Anmeldetag: **07.04.2006**

(84) Benannte Vertragsstaaten:
**DE FR GB IT**

(30) Priorität: **15.04.2005   DE 102005017538**

(62) Dokumentnummer(n) der früheren Anmeldung(en) nach Art. 76 EPÜ:
**06724144.8 / 1 875 318**

(71) Anmelder: **Austriamicrosystems AG**
**8141 Unterpremstätten (AT)**

(72) Erfinder:
• **Denier, Urs**
**8640 Rapperswil (CH)**

• **Sharma, Vivek**
**4600 Olten (CH)**

(74) Vertreter: **Epping - Hermann - Fischer**
**Patentanwaltsgesellschaft mbH**
**Ridlerstraße 55**
**80339 München (DE)**

Bemerkungen:
Diese Anmeldung ist am 30-01-2009 als Teilanmeldung zu der unter INID-Code 62 erwähnten Anmeldung eingereicht worden.

(54)     **Anordnung und Verfahren zur Temperaturkompensation eines Widerstands**

(57)     Es ist eine Anordnung und ein Verfahren zur Temperaturkompensation eines Widerstands (19') angegeben. Ein bezüglich seines Widerstandswerts steuerbarer Widerstand (19') wird mit einem Referenzwiderstand (29) verglichen, der als Switched-Capacitor ausgebildet ist. Ein Vergleicher (27) vergleicht beide Widerstandswerte miteinander. In Abhängigkeit von einem Fehlersignal steuert der Vergleicher (27) den steuerbaren Widerstand (29') sowie einen weiteren steuerbaren Widerstand (19) in einem Nutzsignalpfad an. Somit ist ein temperaturstabiler Widerstand geschaffen.

FIG 9

# FIG 10

**Beschreibung**

Die vorliegende Erfindung betrifft eine Anordnung zur Temperaturkompensation eines Widerstands und ein Verfahren zur Temperaturkompensation eines Widerstands.

In Halbleiter-Schaltungstechnik integrierte Widerstände sind normalerweise verhältnismäßig stark temperaturabhängig. Es kann jedoch wünschenswert sein, einen integrierten Widerstand in temperaturabhängiger oder temperaturkompensierter Weise bereitzustellen. Solche Temperatur-unempfindlichen Widerstände werden unter anderem in Transkonduktanzverstärkern mit hoher Genauigkeit, Transimpedanzverstärkern mit hoher Genauigkeit und in Anwendungen der Medizintechnik eingesetzt, beispielsweise in Messgeräten für den Blutzucker-Gehalt.

In dem Dokument von D. A. Johns, K. Martin: "Analog Integrated Circuit Design", Toronto, Ontario, Canada, Wiley 1997 ist in Kapitel 5.2 auf Seiten 248 bis 250 angegeben, wie On-Chip-Widerstände temperaturstabil bereitgestellt werden können. Dort wird die Transkonduktanz eines Operationsverstärkers dadurch stabilisiert, dass ein hochgenauer und temperaturstabiler externer Widerstand in Form eines nicht integrierten, diskreten Bauteils vorgesehen ist.

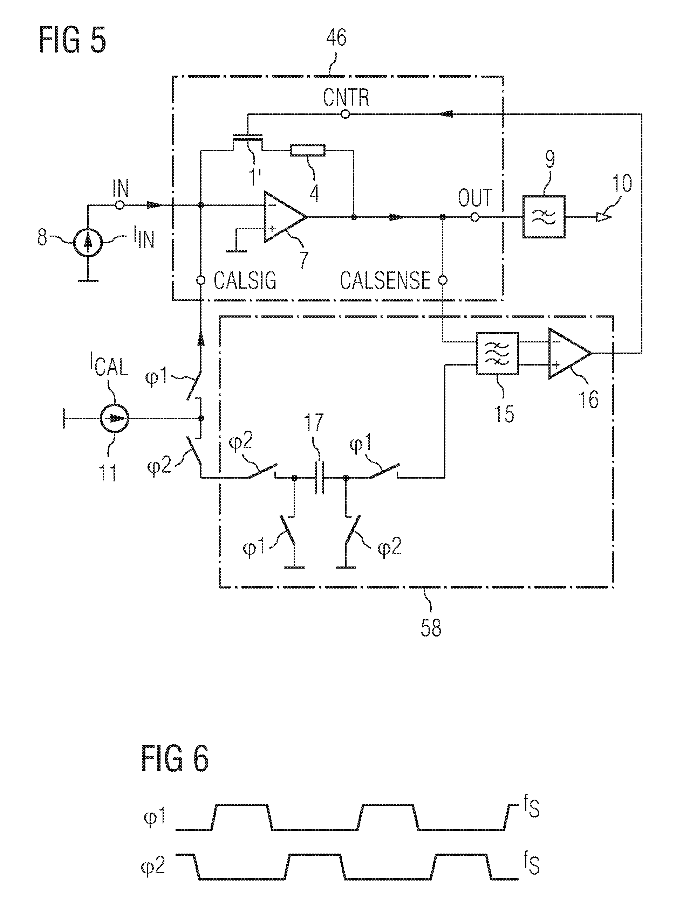

In dem Dokument von A. McLaren und K. Martin: "Generation of Accurate On-Chip Time Constants And Stable Transconductances", IEEE Journal of Solid-State Circuits, Vol. 36, No. 4, April 2001 ist eine Weiterbildung dieses Prinzips dahingehend vorgeschlagen, dass anstelle des externen Referenzwiderstands ein On-Chip-Widerstand eingesetzt wird. Zur Kalibrierung dieses Widerstands ist eine aufwändige analoge Schaltungstechnik vorgesehen sowie ein in zahlreiche, parallelgeschaltete Teilwiderstände, abgestuft in Binär- und Thermometercode, aufgeteilter einstellbarer Bias-Widerstand erforderlich, siehe dort Figur 5.

Bei einer Temperaturvariation um 60 Grad Celsius streut die Transkonduktanz bei diesem Prinzip dennoch um 2,2 Prozent. Dazu kommt, dass die Konvergenz bei einer solchen Schaltung verhältnismäßig langsam ist.

Aufgabe der vorliegenden Erfindung ist es, eine Anordnung und ein Verfahren zur Temperaturkompensation eines Widerstands anzugeben, welche in integrierter Schaltungstechnik realisierbar sind, einen verringerten schaltungstechnischen Aufwand haben und eine präzise Kalibrierung ermöglichen.

Erfindungsgemäß wird die Aufgabe bezüglich der Anordnung gelöst durch eine Anordnung zur Temperaturkompensation eines Widerstands mit den Merkmalen des Patentanspruchs 1.

Bezüglich des Verfahrens wird die Aufgabe gelöst durch ein Verfahren zur Temperaturkompensation eines Widerstands mit den Verfahrensschritten des Anspruchs 7.

Vorteilhafte Weiterbildungen und Ausgestaltungen des vorgeschlagenen Prinzips sind Gegenstand der jeweiligen Unteransprüche.

Nach dem vorgeschlagenen Prinzip wird der Referenzwiderstand dadurch bereitgestellt, dass ein als Widerstand ausgebildeter Switched-Capacitor vorgesehen ist. Die Temperaturkompensation eines Widerstands wird dadurch erzielt, dass der Widerstand gesteuert wird in Abhängigkeit von einem Vergleichsergebnis zwischen dem Widerstandswert des steuerbaren Widerstands und dem Referenzwiderstand, den der Switched-Capacitor als äquivalenten Widerstandswert hat.

Der Switched-Capacitor-Referenzwiderstand ist bevorzugt integriert ausgeführt und hat praktisch eine Temperaturunabhängigkeit. Die Temperaturabhängigkeit eines Switch-Capacitors ist kleiner als 100 ppm pro Kelvin.

Gemäß einer Weiterbildung des vorgeschlagenen Prinzips umfasst der steuerbare Widerstand eine Serienschaltung. Die Serienschaltung weist bevorzugt einen Festwert-Widerstand und den steuerbaren Widerstand auf.

Der Festwert-Widerstand ist bevorzugt als integrierter Poly-Widerstand ausgebildet. Der steuerbare Widerstand ist bevorzugt als Metal-Oxide-Semiconductor, MOS-Transistor ausgebildet, wobei als Widerstand die gesteuerte Strecke und als Steuereingang der Gate-Anschluss des Transistors dient.

Dabei wird der Gesamtwiderstand der Serienschaltung in temperaturunabhängiger Weise konstant gehalten, indem der Gesamtwiderstand der Serienschaltung mit dem Referenzwiderstand verglichen wird und der steuerbare Widerstand in Abhängigkeit von einer eventuellen Abweichung, in Abhängigkeit des Vergleichsergebnisses, gesteuert wird.

Die Steuerung des steuerbaren Widerstands erfolgt nach dem vorgeschlagenen Prinzip in einem Regelkreis so, dass der Gesamtwiderstand der Serienschaltung konstant bleibt.

Der als Switched-Capacitor ausgebildete Referenzwiderstand umfasst bevorzugt eine Kapazität und zumindest einen Schalter zum periodischen Umschalten. Derartige Switched-Capacitor werden auch als geschaltete Kapazität bezeichnet.

Bei einer geschalteten Kapazität wird der Referenzwiderstand durch den geschalteten Kondensator simuliert. Verbindet ein Umschalter die geschaltete Kapazität $C_S$ mit einer Eingangsspannung U, so erhält der Kondensator eine Ladungsmenge Q, die dem Produkt aus dem Kapazitätswert und der Eingangsspannung entspricht. In der anderen Schalterstellung gibt der Kondensator die gleiche Ladung wieder ab. Diese Ladung überträgt er also in jeder Schaltperiode $T_S$ vom Eingang zum Ausgang der Schaltung. Auf diese Weise kommt ein Stromfluss I zustande, der sich im Mittel einstellt zu

$$I = C_S \cdot \frac{U}{T_S} = C_S \cdot U \cdot f_S \; .$$

Somit lässt sich die Grundäquivalenz zwischen der geschalteten Kapazität und einem ohmschen Widerstand angeben als

$$R = \frac{1}{C_S \cdot f_S} \; ,$$

wobei R der äquivalente Widerstand ist. Bemerkenswert ist der lineare Zusammenhang zwischen der Schaltfrequenz $f_S$ und dem äquivalentem Leitwert.

Der Kondensator im Switched-Capacitor Referenzwiderstand kann beispielsweise als sogenannte Poly-Poly- oder Metall-Metall-Struktur ausgebildet sein.

Folglich hängt der Wert des Referenzwiderstands bei einem geschalteten Kondensator nur von der Schaltfrequenz und dem Kapazitätswert ab. Der Temperaturkoeffizient des Kapazitätswerts ist verhältnismäßig klein und beträgt beispielsweise circa 30 ppm pro Kelvin.

Die praktische Realisierung einer solchen Schaltung ist verhältnismäßig einfach. Das Prinzip konvergiert sehr schnell und benötigt nur wenige Bauteile zu seiner Realisierung. Zu dem bietet es eine große Flexibilität in der Wahl der Kalibrierparameter, was wertvoll für eine kosteneffiziente Implementierung sein kann.

Der Referenztakt zur Ansteuerung des als Switched-Capacitor ausgebildeten Referenzwiderstands wird bevorzugt von einem Referenztaktgenerator bereitgestellt. Der Referenztaktgenerator steuert bevorzugt den Schalter zum periodischen Umschalten an.

Der steuerbare Widerstand ist bei einer Ausführung im Rückführungszweig eines Verstärkers angeordnet. Damit kann nicht nur ein Widerstand mit hoher Temperaturkonstanz bereitgestellt werden, sondern auch ein Verstärker mit temperaturunabhängiger Transkonduktanz oder Transimpedanz.

Bei Ausführung des steuerbaren Widerstands als Serienschaltung ist der Festwert-Widerstand bevorzugt als Poly-Silizium-Widerstand in integrierter Form ausgebildet. Der steuerbare Widerstand in dieser Serienschaltung ist ein abstimmbarer Metal Oxide Semiconductor, MOS-Transistor, der bevorzugt im linearen Bereich betrieben wird.

Weiter bevorzugt ist die Temperaturkompensation durch Verwendung eines Kalibrierstromsignals nach dem Chopping-Prinzip ausgebildet. Dieses Chopping-Kalibriersignal kann beispielsweise mit einer kleinen Stromquelle und einem Schalter erzeugt werden. Die Taktrate ist dabei so gewählt, dass das Kalibriersignal frequenzmäßig ausreichend weit von dem Nutzfrequenzbereich eines zu verarbeitenden Nutzsignals entfernt liegt.

Die Höhe des Kalibrierstroms gemäß Referenztakt ist bevorzugt klein, um eine Begrenzung des Dynamikbereichs des Nutzsignalpfads zu vermeiden.

In der Ausführung des vorgeschlagenen Prinzips ist zusätzlich zu dem steuerbaren Widerstand ein weiterer steuerbarer Widerstand mit steuerbarem Widerstandswert vorgesehen und in einem Nutzsignalpfad angeordnet. Demnach dient der weitere steuerbare Widerstand mit steuerbarem Widerstandswert zur eigentlichen Nutzsignalverarbeitung, während der mit dem Referenzwiderstand zu vergleichende steuerbare Widerstand in einem Hilfszweig gebildet ist. Dieser steuerbare Widerstand kann auch als Dummy-Bauteil verstanden werden. Dadurch entfällt die Überlagerung des Nutzsignals mit einem Chopping-Signal. Dieser Dummy-Widerstand dient zum Erzeugen eines Ausgangsstroms, der mit einem äquivalentem Referenzstrom verglichen wird. Der äquivalente Referenzstrom ist in einem Switched-Capacitor-Widerstand erzeugt. Beide Ströme werden mit einem Fehlerverstärker verglichen. Der Fehlerverstärker erzeugt ein Steuersignal, das zur Steuerung des steuerbaren Widerstands und des weiteren steuerbaren Widerstands dient. Dieses Steuersignal dient zur Veränderung den steuerbaren Widerstandswerts solange, bis beide Ströme, die der Vergleicher vergleicht, gleich sind.

Bevorzugt wird das Steuersignal durch einen Schleifenfilter geführt, der die Stabilität die Regelschleife garantiert. Ein trotzdem verbleibender Temperaturdrift hängt ab von der Genauigkeit einer Referenzspannung, dem Temperaturdrift des kapazitiven Referenzelements im Switched-Capacitor-Referenzwiderstand, einer Temperaturdrift einer Taktquelle und einer Temperaturdrift eines bevorzugt vorgesehenen Stromspiegels. Zur Erzeugung einer stabilen Referenzspannung kann beispielsweise eine Bandgap-Generatoranordnung vorgesehen sein. Solche Bandgaps haben beispielsweise einen Temperaturkoeffizienten von weniger als 15 ppm pro Kelvin. Quarz-Taktgeneratoren haben exzellente, geringe Temperaturkoeffizienten von beispielsweise sehr viel kleiner als 1 ppm pro Kelvin. Demnach trägt hauptsächlich der Referenzkondensator im Switched-Capacitor-Referenzwiderstand zum Temperaturdrift, der noch verbleibt, bei, beispielsweise mit 43 ppm pro Kelvin. Selbst bei einer Worst-Case-Abschätzung aller dieser Ursachen für einen Temperaturdrift bleibt dieser insgesamt deutlich unter 100 ppm pro Kelvin, was eine signifikante Verbesserung, bei zusätzlich besonders einfacher Schaltungsrealisierung, ist. Aufgrund der in dieser Weiterbildung vorgeschlagenen Verwendung einer Kopie des steuerbaren Widerstands werden jegliche Fehler vermieden, die durch Ladungsinjektionen aus dem Switched-Capacitor-Schaltkreis in den Nutzsignalpfad auftreten könnten.

Auch bei dieser Weiterbildung ist der steuerbare Widerstand bevorzugt in einer Serienschaltung aus einem Festwert-Widerstand und dem steuerbaren Widerstand gebildet.

Weiter bevorzugt ist der Fehlerverstärker, nämlich der Vergleicher, in Switched-Capacitor-Technik ausgebildet.

Auch ein Schleifenfilter zur Filterung des Steuersignals, das der Vergleicher abgibt, ist bevorzugt in Switched-Capacitor-Technik ausgebildet.

Die Erfindung wird nachfolgend an mehreren Ausführungsbeispielen anhand von Zeichnungen näher erläutert.

Es zeigen:

Figur 1          ein erstes Ausführungsbeispiel einer Anordnung,

Figur 2          ein zweites Ausführungsbeispiel einer Anordnung,

Figur 3          eine beispielhafte Weiterbildung der Schaltung von Figur 2 mit einem Chopping-Prinzip,

Figuren 4a und 4b     das Verhältnis von Taktfrequenz und Nutzfrequenzbereich bei der Schaltung von Figur 3,

Figur 5          eine andere, beispielhafte Weiterbildung der Schaltung nach Figur 2 mit einem Chopping-Prinzip,

Figur 6          ein beispielhaftes Taktsignal zur Ansteuerung der Schalter von Figuren 3 und 5,

Figur 7          eine beispielhafte Weiterbildung der Schaltung von Figur 5 für mehrere Kanäle,

Figur 8          beispielhafte Taktsignale zur Ansteuerung der Schalter von Figur 7,

Figur 9          ein Ausführungsbeispiel eines Nutzsignalverstärkers mit steuerbaren Rückkopplungswiderstand nach dem vorgeschlagenen Prinzip, und

Figur 10         ein Ausführungsbeispiel einer Schaltung nach dem vorgeschlagenen Prinzip zur Ansteuerung des Widerstands von Figur 9,

Figur 11         beispielhafte Signale zur Ansteuerung der Schalter von Figur 10 in vier Taktphasen und

Figur 12         den beispielhaften Signalverlauf eines Vergleichssignals gemäß Figur 10.

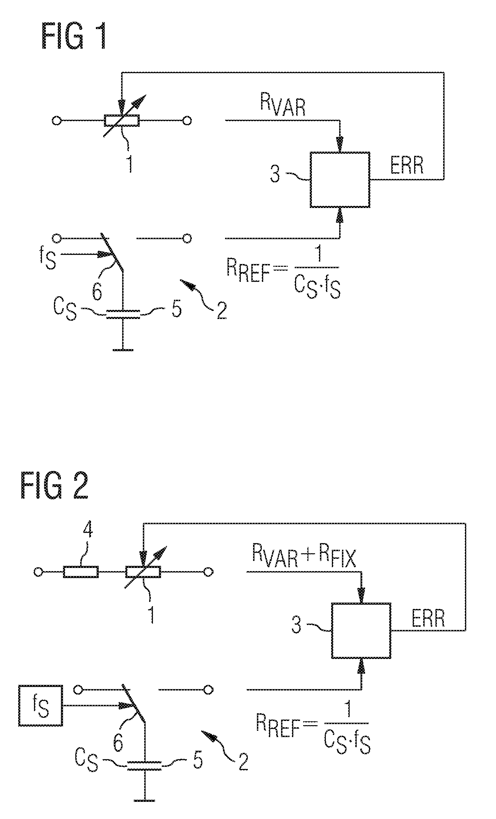

Figur 1 zeigt eine beispielhafte Anordnung zur Temperaturkompensation eines Widerstands nach dem vorgeschlagenen Prinzip. Es ist ein bezüglich seines Widerstandswerts steuerbarer Widerstand 1 vorgesehen. Außerdem umfasst die Anordnung einen Referenzwiderstand 2, der als Switched-Capacitor ausgebildet ist. Ein Vergleicher 3 hat zwei Eingänge. Ein erster Eingang ist mit dem steuerbaren Widerstand 1 zur Übermittlung des Widerstandswerts des steuerbaren Widerstands 1 oder eines davon abgeleiteten Signals gekoppelt. Der zweite Eingang des Vergleichers 3 ist mit dem Referenzwiderstand 2 zur Übermittlung des Referenzwiderstandswerts oder eines davon abgeleiteten Werts gekoppelt. Ein Ausgang des Vergleichers ist ausgebildet zum Abgeben eines Fehlersignals. Das Fehlersignal ist abhängig von einer Abweichung des Widerstandswerts des steuerbaren Widerstands vom Widerstandswert des Referenzwiderstands. Der Ausgang des Vergleichers 3 ist mit einem Steuereingang des steuerbaren Widerstands 1 verbunden.

Der als Switched-Capacitor ausgebildete Referenzwiderstand 2 umfasst einen Referenzkondensator 5 und einen Schalter 6. Der Schalter 6 wird in einer Taktfrequenz $f_S$ eines Referenztakts angesteuert. Der äquivalente Widerstand dieses Switched-Capacitor Referenzwiderstands berechnet sich gemäß der Vorschrift aus dem reziproken Produkt des Kapazitätswerts $C_S$ des Kondensators 5 und der Taktfrequenz $f_S$ des Referenztakts, der den Schalter 6 ansteuert.

Der Vergleicher vergleicht den Widerstandswert des steuerbaren Widerstands mit dem Widerstandswert des Referenzwiderstands. Sobald eine temperaturbedingte Abweichung des Widerstandwerts des steuerbaren Widerstands 1 festgestellt wird, gibt der Vergleicher ein Fehlersignal derart ab, dass der Widerstandswert des steuerbaren Widerstands 1 dem Widerstandswert des temperaturstabilen Referenzwiderstands nachgeführt wird.

Somit ist eine hoch präzise Temperaturkompensation des steuerbaren Widerstands 1 erzielt. Temperaturabhängigkeiten des Widerstandswerts des steuerbaren Widerstands 1 werden praktisch vollständig ausgeregelt.

Figur 2 zeigt eine Weiterbildung der Schaltung von Figur 1, die in den verwendeten Bauteilen, deren Funktionsweise und den dadurch erzielten Vorteilen weitgehend übereinstimmen. Anstelle des steuerbaren Widerstands 1 von Figur 1 ist bei Figur 2 eine Serienschaltung vorgesehen, die einen Festwert-Widerstand 4 und einen steuerbaren Widerstand 1' umfasst. Bei der Schaltung von Figur 2 wird der Widerstandswert der Serienschaltung des Festwert-Widerstands 4 und des steuerbaren Widerstands 1' mit dem Referenzwiderstand 2 verglichen. Der Festwert-Widerstand 4 kann beispielsweise als Polysilizium-Widerstand ausgebildet sein und somit eine verhältnismäßig große Temperaturabhängigkeit haben, die mit dem steuerbaren Widerstand 1' und dem beschriebenen Regelkreis kompensiert wird. Somit wird die Summe aus dem Widerstandswert des Festwert-Widerstands 4 und dem steuerbaren Widerstand 1' stets konstant gehalten, auch bei starken Veränderungen der Umgebungstemperatur.

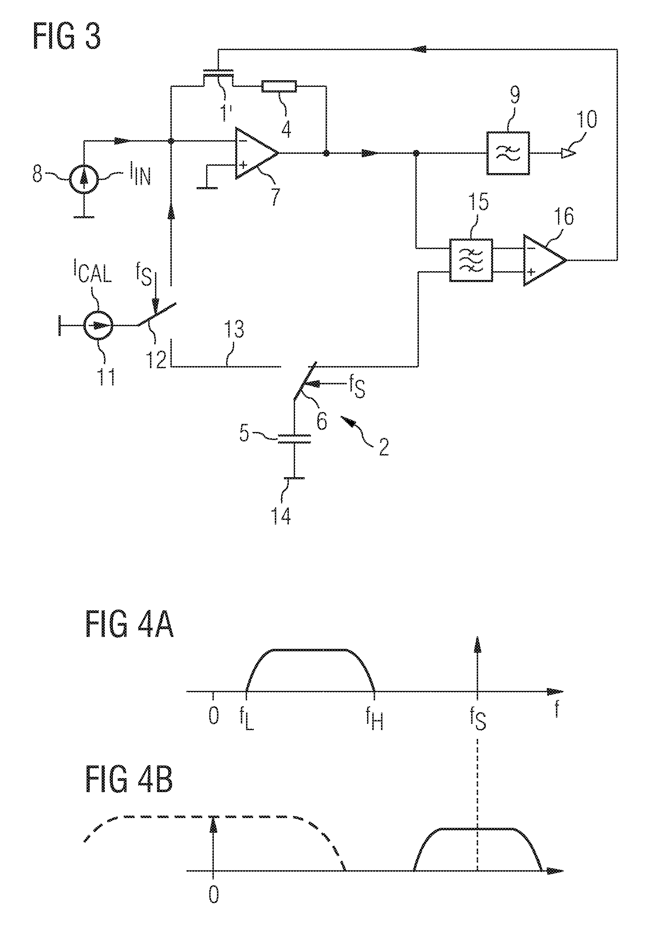

Figur 3 zeigt eine Weiterbildung der Schaltung von Figur 2 nach einem Chopping-Prinzip. Dabei wird ein Kalibriersignal einem zu verarbeitenden Nutzsignal überlagert. Im Einzelnen ist im vorliegenden Ausführungsbeispiel die Serienschaltung umfassend den Festwert-Widerstand 4 und den steuerbaren Widerstand 1' zwischen einen Ausgang eines Operationsverstärkers 7 und einen invertierenden Eingang des Operationsverstärkers 7 geschaltet. Der Operationsverstärker 7 ist als Transimpedanzverstärker ausgebildet. Der steuerbare Widerstand 1' ist als Metal Oxide Semiconductor, MOS-Transistor ausgebildet. Der Operationsverstärker 7 ist in einem Nutzsignalpfad angeordnet, wobei an seinen invertierenden Eingang zusätzlich eine Nutzsignal-Quelle 8 angeschlossen ist. Die Nutzsignal-Quelle gibt einen Eingangsstrom $I_{IN}$ ab. Der Ausgang des Operationsverstärkers 7 ist über ein Tiefpassfilter 9 an einen Ausgang 10 des Nutzsignalpfads angeschlossen.

Eine gemeinsame Stromquelle 11 ist über einen Umschalter 12 umschaltbar entweder mit dem invertierenden Eingang des Operationsverstärkers 7 oder mit einem zweiten Strompfad 13 verbunden. Dabei gibt die gemeinsame Stromquelle 11 einen Kalibrierstrom $I_{CAL}$ ab. Der nicht-invertierende Eingang des Operationsverstärkers 7 ist mit einem Bezugspotenzialanschluss verbunden. Der zweite Strompfad 13 umfasst einen als Switched-Capacitor 2 ausgebildeten Referenzwiderstand, welcher wiederum eine Kapazität 5 und einen Umschalter 6 umfasst. Die Kapazität ist mit ihrem freien Anschluss mit einem Bezugspotentialanschluss 14 verbunden. Sowohl der Umschalter 12 für die gemeinsame Stromquelle 11, als auch der Umschalter 6 für den Switched-Capacitor Referenzwiderstand 2 sind von einem Referenztakt mit der Referenzfrequenz $f_S$ gesteuert. Der Ausgang des Operationsverstärkers 7 ist unter Bildung eines ersten Strompfads über ein Bandpassfilter 15 mit einem Eingang eines Vergleichers 16 verbunden. Ebenso ist der zweite Strompfad 13, der den Referenzwiderstand 2 umfasst, über das Bandpassfilter 15 mit einem zweiten Eingang des Vergleichers 16 verbunden. Der Ausgang des Vergleichers 16 ist unter Bildung einer Regelschleife mit dem Gate-Anschluss des als Transistor ausgebildeten, steuerbaren Widerstands 1' verbunden.

Temperaturschwankungen des als integrierter Poly-Widerstand ausgebildeten Festwert-Widerstands 4 werden automatisch in einer Kalibrierung kompensiert. Der MOS-Transistor 1' wird in seinem linearen Bereich betrieben. Der Gesamtwiderstand dieser Serienschaltung 4, 1' wird mit dem Referenzwiderstand 2, dem äquivalenten Widerstand des geschalteten Kondensators 5, verglichen.

Der Referenzkondensator 5 ist als Poly-Poly- oder Metall-Metall-Struktur ausgebildet. Der äquivalente Referenzwiderstand des Referenzwiderstands 2 hängt nur von der Schaltfrequenz $f_S$ und dem Kapazitätswert des Kondensators 5 ab, dessen Temperaturkoeffizient verhältnismäßig klein ist, beispielsweise zirka 30 ppm pro Kelvin.

Ein kleiner Kalibrierstrom wird mit der Kalibrierstromquelle 11 erzeugt unter Benutzung einer Kommutation. Dieser Kalibrierstrom wird zur Messung des Widerstands 4, 1' sowie des Referenzwiderstands 2 und zu deren Vergleich verwendet. Hierzu ist ein periodisches Umschalten mit der Schaltfrequenz $f_S$ vorgesehen. Mit einer Filterung 15 und einem Vergleich 16 wird ein Steuersignal erzeugt, das die Gate-Source-Spannung des MOS-Transistors 1' steuert und somit den Widerstand von dessen gesteuerter Strecke ändert.

Die praktische Realisierung des Prinzips ist sehr einfach und das Kalibrieren kann kontinuierlich im Hintergrund ablaufen, ohne die Nutzsignalverarbeitung zwischen dem Generator 8 und dem Ausgang 10 des Nutzsignalpfads zu unterbrechen. Dieses Prinzip arbeitet sehr schnell und benötigt nur wenige Komponenten. Außerdem ist eine große Flexibilität gegeben.

Die Kalibrierung wird demnach vorliegend mittels eines gechoppten Kalibrierstromsignals ausgeführt. Dieses Chopping-Signal wird in einfacher Weise mit der Kalibrierstromquelle 11 und dem Schalter 12 erzeugt. Die Taktrate $f_S$ für den Schalter 12 ist so gewählt, dass das Kalibriersignal in ausreichendem Abstand von dem Nutzfrequenzbereich, zugeführt von der Nutzsignalquelle 8, liegt, wobei der Transimpedanzverstärker 7 in diesem Nutzfrequenzbereich arbeitet. Prozess-und Temperaturschwankungen des Kalibrierstroms der Quelle 11 haben keinen Einfluss auf die Eigenschaften und Qualität des Kalibriervorgangs, da der gleiche Kalibrierstrom $I_{CAL}$ sowohl durch den Referenzwiderstand im zweiten Strompfad 13 fließt, als auch durch den ersten Strompfad, der den Festwert-Widerstand 4 und den gesteuerten Widerstand 1' umfasst. Die Größe des Kalibrierstroms kann klein sein, um eine Begrenzung des Dynamikbereichs der Nutzsignalverarbeitung zu vermeiden.

Das Bandpassfilter 15 umfasst Mittel zum Demodulieren des Chopping-Signals mittels eines einfachen Choppers und nachgeschalteter Filterung. Die Filterung dient dazu, das Nutzsignal zu eliminieren, welches nunmehr auf die Chopping-Frequenz konvertiert ist. Der Vergleich im Vergleicher 16 kann mit einem einfachen einstufigen Verstärker durchgeführt werden, dessen Ausgang zum Abstimmen des Widerstands 1' dient. Dadurch ist sichergestellt, dass der Zielwiderstand 1', 4 als Serienschaltung dem Referenzwiderstand 2 folgt.

Da das Nutzsignal am Ausgang des Verstärkers 7 in geringem Anteil das Kalibriersignal außerhalb des Nutzfrequenzbereichs umfasst, kann dieses mit dem Tiefpassfilter 9 in einfacher Weise entfernt werden. Noch einfacher ist die Entfernung der Kalibrieranteile im Nutzsignal im Digitalen nach einer Analog/Digital-Wandlung.

Vorliegend ist das Kalibrierprinzip anhand eines Transimpedanzverstärkers 7 gezeigt. Selbstverständlich kann das Prinzip im Rahmen der Erfindung auch auf andere Schaltkreiskonfigurationen angewandt werden mit Abwandlungen, die im Rahmen fachmännischen Handelns liegen. Beispielsweise kann das Kalibriersignal eine Spannung oder ein Strom sein und die Art des Vergleichs und der Kalibrierung kann ein Stromvergleich, ein Spannungsvergleich oder ähnliches sein. Die Stärke und Frequenz des Kalibriersignals kann entsprechend der Anwendung angepasst sein. Es ist dabei wünschenswert, die Frequenz des Kalibriersignals in ausreichendem Abstand vom Nutzsignalfrequenzband zu halten, sei es bei höherer, oder bei geringerer Frequenz. Dadurch ist es möglich, ein sehr kleines Kalibriersignal bezüglich seiner Amplitude zu verwenden. Ein vereinfachtes Filterdesign ist möglich. Die Filter können RC-, $G_mC$-oder SC-Filter sein.

Figur 4a zeigt beispielhaft das Frequenzband des Nutzsignals zwischen unterer und oberer Frequenz $f_L$, $f_H$. Man erkennt, dass die Taktfrequenz $f_S$ des Kalibriersignals in ausreichendem Abstand vom Nutzsignalband für die beschriebenen Filtervorgänge liegt.

Figur 4b zeigt das gleiche Signalspektrum wie bei Figur 4a, jedoch nach dem Choppen. Die Chopping-Frequenz ist dabei gerade die Taktfrequenz $F_S$. Die gestrichelte Linie entspricht der Filtercharakteristik. Das Nutzsignalband ist auf die Chopping-Frequenz moduliert.

Figur 5 zeigt eine Weiterbildung der Schaltung von Figur 3, wobei sich die Schaltungen in den verwendeten Bauteilen und deren vorteilhafter Verschaltung weitgehend entsprechen. Anstelle der Umschalter 12, 6 von Figur 3 sind vorliegend einzelne Schalter vorgesehen. Die Kapazität 5 ist durch eine Längskapazität 17 ersetzt. Diese ist mit vier Schaltern ausgebildet, jedoch nach wie vor ein Switched-Capacitor-Referenzwiderstand. Zwischen dem Eingang IN und dem Ausgang OUT ist ein Nutzsignalpfad als erster Strompfad umfassend den Operationsverstärker 7 mit Rückführungszweig 1', 4 geschaltet.

Figur 6 zeigt beispielhafte Signale zum Ansteuern der Schalter φ1, φ2, wie dort bezeichnet. Man erkennt, dass beide Steuersignale bei der gleichen Chopping-Frequenz $f_S$ arbeiten und geforderte Nichtüberlappungszeiten einhalten.

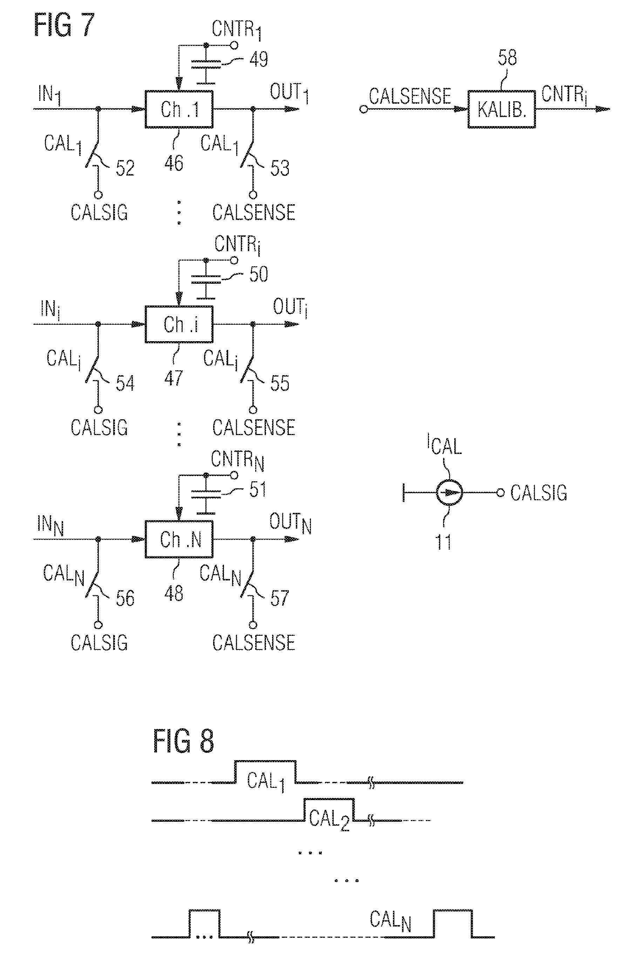

Figur 7 zeigt eine beispielhafte Weiterbildung der Schaltung von Figur 5 für mehrere Kanäle zur Verarbeitung mehrerer Nutzsignale. Deren Kalibrierung erfolgt gemäß dem vorgeschlagenen Prinzip wie beispielhaft anhand von Figur 5 erläutert.

Dabei ist der Kalibrierpfad nur einmal vorhanden. Die Kalibrierung der einzelnen Kanäle erfolgt nacheinander in einem Zeitmultiplex-Betrieb. Dabei wird jeweils ein Kanal kalibriert, während die übrigen Kanäle jeweils nur der Nutzsignalverarbeitung dienen. Im Einzelnen sind beispielhaft drei Kanäle 46, 47, 48 vorgesehen, die zur Verarbeitung je eines Nutzsignals eingerichtet und zwischen einem Eingang IN und einem Ausgang OUT gebildet sind. An Ein- und Ausgang IN, OUT sind jeweils Schalter 52 bis 57 angeschlossen. Die eingangsseitigen Schalter 52, 54, 56 dienen je zum Zuführen eines Kalibriersignals CALSIG in einem Kalibrierbetrieb des jeweiligen Nutzsignalpfads. Das Kalibriersignal CALSIG wird von der Stromquelle 11 bereitgestellt. Im Kalibrierbetrieb des jeweiligen Nutzsignalpfads wird über den ausgangsseitigen Schalter 53, 55, 57 ein Abtastsignal CALSENSE ausgekoppelt und einer Kalibriereinrichtung 58 zugeführt, die beispielsweise den in Figur 5 gezeigten Aufbau haben kann. Die Kalibriereinrichtung 58 dient zum Bereitstellen eines Steuersignals CNTR für den jeweils kalibrierten Nutzsignalpfad 46, 47, 48, in dessen Abhängigkeit wiederum der steuerbare Widerstand 1' eingestellt wird. Zur Speicherung des jeweiligen Steuersignals CNTR ist an jedem Steueranschluss der Nutzsignalpfade ein Kondensator 49, 50, 51 angeschlossen, der gegen Masse geschaltet ist. Somit kann jeder Kanal 46, 47, 48 einige Taktperioden lang kalibriert werden. Das resultierende Steuersignal CNTR wird auf dem Kondensator 49, 50, 51 gespeichert und dient zum Einstellen des Widerstandswerts des steuerbaren Widerstands 1'. Anschließend wird die Kalibrierung des nächsten Kanals 47, 48, 46 durchgeführt. Die relativ geringen Leckströme integrierter Kondensatoren und die verhältnismäßig großen Zeitkonstanten bezüglich Temperaturänderungen erlauben es, einen Kanal 46, 47, 48 für eine verhältnismäßig lange Zeitdauer ohne gleichzeitige Kalibrierung zu betreiben. Demnach kann praktisch ohne Nachteile bezüglich der Genauigkeit eine deutliche Einsparung von Chipfläche und elektrischer Leistung erzielt werden, da lediglich ein Kalibrierpfad für mehrere Nutzsignalpfade benötigt wird. Außerdem genügt ein einziges, hochpräzises Kalibriersignal CALSIG, das mit solcher Präzision nicht bereitgestellt werden könnte, wenn für jeden Kanal ein eigenes Kalibriersignal nötig wäre. Da, wie oben bereits ausführlich erläutert, das Kalibriersignal und das Nutzsignal verschiedene Frequenzbänder nutzen, kann auch derjenige Kanal, der gerade kalibriert wird, ohne Unterbrechung zur Verarbeitung des Nutzsignals dienen.

Figur 8 zeigt beispielhafte Taktsignale zur Ansteuerung der Schalter von Figur 7. Diese Steuersignale CAL1, CAL2, ... , CalN aktivieren die jeweils zugeordneten Schalter in Figur 7 periodisch nacheinander zur Erzielung des Zeitmultiplexbetriebs. Somit wird in je einem der Nutzsignalpfade 46, 47, 48 eine Kalibrierung nach dem vorgeschlagenen Prinzip durchgeführt, während in den je übrigen Kanälen keine Überlagerung des Nutzsignals durch ein Kalibriersignal vorgesehen ist.

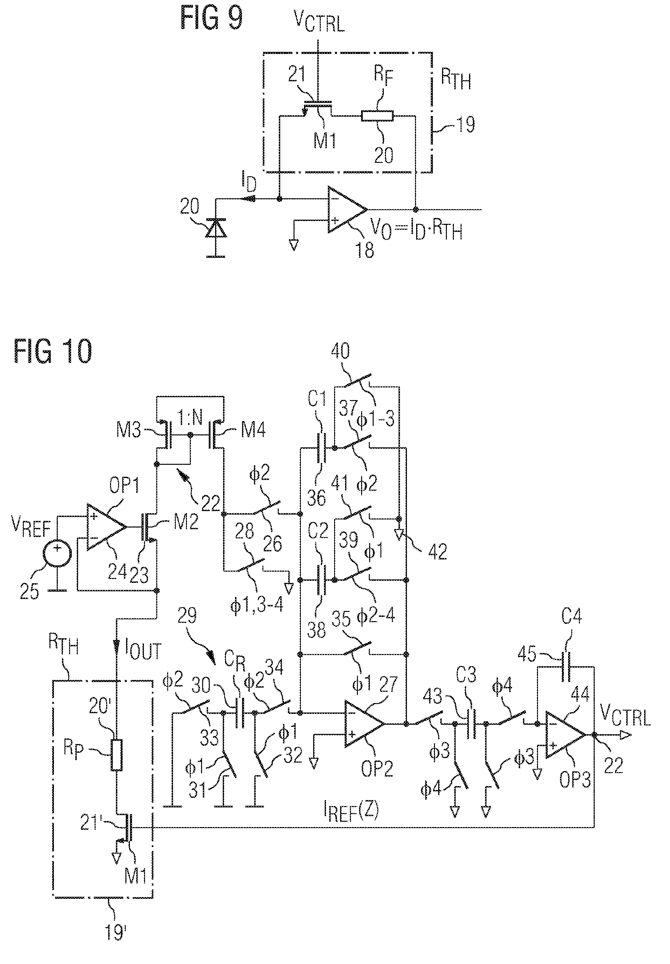

Figur 9 zeigt ein Ausführungsbeispiel des vorgeschlagenen Prinzips mit einem Transimpedanzverstärker 18, dessen Ausgang über eine Serienschaltung 19 mit einem invertierenden Eingang des Transimpedanzverstärkers 18 verbunden ist. Der invertierende Eingang bildet zugleich den Eingang des Transimpedanzverstärkers, an den eine rückwärts vorgespannte Fotodiode 20 angeschlossen ist. Der Rückführungszweig umfasst die Serienschaltung 19 mit einem weiteren Festwert-Widerstand 20 und einem weiteren steuerbaren Widerstand 21. Der weitere steuerbare Widerstand 21 umfasst einen Metal Oxide Semiconductor, MOS-Transistor mit einem Steuereingang und einer gesteuerten Strecke. Die Steuerspannung für den steuerbaren Widerstand 21 wird von einer Schaltung gemäß Figur 10 bereitgestellt, wie nachfolgend erläutert. Der optische Empfänger gemäß Figur 9 benötigt eine sehr präzise Transimpedanz, die vor allem temperaturunabhängig ist. Wenn der Widerstand 20 wie bevorzugt als Halbleiterwiderstand aus dotiertem polykristallinem Halbleitermaterial wie polykristallinem Silizium aufgebaut ist, hat er einen Temperaturdrift von typisch 600 ppm pro Kelvin. Der Transimpedanzverstärker nach Figur 9 konvertiert den Fotodiodenstrom in eine Ausgangsspannung, die weiterverarbeitet werden kann. Die Verstärkung eines solchen Schaltkreises wird durch den Rückkopplungswiderstand 19 definiert. Eine hoch präzise Verstärkung ist für hoch genaue Sensoranwendungen benötigt, beispielsweise Glukosemessgeräte für den Blutzucker-gehalt. Daher ist eine Temperaturkompensation nötig, um einen temperaturdriftfreien Widerstand zu schaffen. Insbesondere muss der Temperaturdrift kleiner als circa 200 ppm pro Kelvin sein.

Mit der nachfolgend erläuterten Schaltung gemäß Figur 10 nach dem vorgeschlagenen Prinzip kann der Widerstand der Serienschaltung weitgehend frei von Temperaturdrifts gehalten werden, somit auch die Transimpedanz des Verstärkers.

Figur 10 zeigt eine Schaltung zur Erzeugung einer Abstimmspannung $V_{CTRL}$ an einem Ausgang 22, die zum Abstimmen des Transistors 21 von Figur 9 in Temperatur kompensierender Weise dient. Hierfür umfasst die Schaltung von Figur 10 eine Kopie der Serienschaltung 19 von Figur 9, die als Serienschaltung 19' bezeichnet ist. Diese Serienschaltung 19' umfasst eine einen Festwert-Widerstand 20' einen steuerbaren Widerstand 21', je als Kopie der entsprechenden Bauteile 20, 21 der Serienschaltung 19 von Figur 9. Der Steuereingang des steuerbaren Widerstands 21' ist ebenfalls mit dem Ausgang 22 verbunden. Ein Eingang eines Stromspiegels 22 ist über die gesteuerte Strecke eines Transistors 23 mit einem Anschluss der Serienschaltung 19' verbunden, die außerdem mit einem Bezugspotenzialanschluss verbunden ist. Der Transistor 23 hat einen Gate-Anschluss, der mit dem Ausgang eines Verstärkers 24 verbunden ist. Der nicht-invertierende Eingang des Verstärkers 24 ist mit einer Referenzspannungsquelle 25 verbunden, während der invertierende Eingang des Verstärkers 24 mit dem Spannungsknoten verbunden ist, der den Transistor 23 mit der Serienschaltung 19' verbindet. Ein Ausgang des Stromspiegels 22, der ein Übersetzungsverhältnis 1:N hat, ist über einen Schalter 26 in einer zweiten Taktphase φ2 mit einem invertierendem Eingang eines Vergleichers 27 verbunden. Außerdem ist der Ausgang des Stromspiegels 22 über einen Schalter 28 in einer ersten, dritten und vierten Taktphase φ1, φ3, φ4 mit einem Bezugspotenzialanschluss gekoppelt. Ein Switched-Capacitor-Referenzwiderstand 29 ist ebenfalls mit dem invertierenden Eingang des Vergleichers 27 verbunden. Je ein Anschluss des vom Switched-Capacitor-Referenzwiderstand 29 umfassten Kondensators 30 ist über je einen Schalter 31, 32 in einer ersten Taktphase φ1 gegen Bezugspotenzial schaltbar. Außerdem sind Schalter 33, 34 vorgesehen, die in einer zweiten Taktphase φ2 den Kondensator 30 zwischen den invertierenden Eingang des Vergleichers 27 und einen Bezugspotenzialanschluss schalten.

Der Vergleicher 27 ist selbst als Switched-Capacitor Verstärker ausgebildet. Hierfür umfasst ein Rückführungszweig drei parallel geschaltete Zweige. Ein erster Zweig zwischen dem Ausgang des Vergleichers 27 und seinem invertierenden Eingang umfasst einen in einer ersten Taktphase φ1 aktivierbaren Schalter 35. Ein zweiter Zweig umfasst einen Kondensator 36, der in Serie mit einem Schalter 37 zum Betätigen in einer Taktphase φ2 geschaltet ist. Ein zweiter Kondensator 38 bildet ebenfalls eine Serienschaltung mit einem Schalter 39 in einem dritten Rückführungszweig. Der Schalter 39 ist in der zweiten bis vierten Taktphase φ2, φ3, φ4 geschlossen. Weitere Schalter 40, 41 dienen zum Verbinden eines Knotens zwischen dem ersten und zweiten Kondensator 36, 38 und dem zugeordneten Schalter 37, 39 mit einem Bezugspotenzialanschluss 42. Dabei ist der weitere Schalter 40, der dem ersten Kondensator 36 zugeordnet ist, in der ersten und dritten Taktphase φ1, φ3 geschlossen. Der weitere Schalter 41, der dem zweiten Kondensator 38 zugeordnet ist, wird in der ersten Taktphase φ1 geschlossen. Der Ausgang des Vergleichers 27, der einen Fehlerverstärker realisiert, ist über ein Schleifenfilter an den Ausgang 22 geschaltet. Das Schleifenfilter umfasst einen Switched-Capacitor 43, der als geschalteter Kondensator zwischen den Ausgang des Verstärkers 27 und einen invertierenden Eingang eines weiteren Verstärkers 44 geschaltet ist. Vier Schalter am geschalteten Kondensator des Switched Capacitor 43 dienen dazu, diesen in der dritten Taktphase φ3 aufzuladen mit dem Ausgangssignal des Verstärkers 27, und in der vierten Taktphase φ4 zu entladen an den Eingang des weiteren Verstärkers 44. Der weitere Verstärker 44 hat eine Kapazität 45 im Rückführungszweig zwischen seinem Ausgang, der mit dem Ausgang 22 verbunden ist, und seinem invertierenden Eingang. Der nicht-invertierende Eingang des Verstärkers 44 ist gegen Bezugspotenzial geschaltet. Die Kondensatoren 43, 45 dienen zum Stabilisieren der Regelschleife. Die Kondensatoren 36, 38 im Rückführungszweig des Fehlerverstärkers definieren den Restfehler.

Gemäß Figur 10 werden eine Bandgap-Spannungsquelle 25 und ein Referenzwiderstand 29 als Referenzbauteile verwendet. Dies dient mit der verwendeten Schaltungsimplementierung zur Bereitstellung eines Widerstands 19 mit deutlich geringerer Temperaturabhängigkeit. Die Schaltung nach Figur 10 erzeugt eine temperaturabhängige Steuerspannung unter Verwendung eines Regelkreises im Ausgang 22, die mit einem Referenzgenerator erzeugt wird. Der MOS-Transistor 21 beziehungsweise 21' addiert einen zusätzlichen Widerstand zum Rückkopplungswiderstand 19, 19', was einen Temperaturdrift kompensiert. Eine Nachbildung dieser Serienschaltung 19' im Regelkreis nach Figur 10 wird benutzt, um einen Ausgangsstrom Iout zu erzeugen. Der Ausgangsstrom wird mit einem äquivalentem Referenzstrom verglichen, der von einem Switched-Capacitor 29 erzeugt wird. Beide Ströme werden mit dem Fehlerverstärker 27 verglichen, der, nach einem Filter 43, 44, 45, die Steuerspannung erzeugt. Diese Steuerspannung wiederum variiert den Widerstandswert des Widerstands 21' solange, bis der Ausgangsstrom Iout und der vom Switched-Capacitor 29 erzeugte Referenzstrom gleich sind. Das Schleifenfilter 43 bis 45 stabilisiert die Regelschleife und ist selbst in Switched-Capacitor-Technik ausgebildet. Der verbleibende Temperaturdrift wird demnach festgelegt von der Genauigkeit der Referenzquelle 25, dem Temperaturdrift des Referenzkondensators 30, dem Temperaturdrift der Referenztaktquelle, die die Schalter von Figur 10 ansteuert und einem Temperaturdrift des Stromspiegels 22. Der Bandgap-Spannungsgenerator 25 hat einen Temperaturkoeffizienten von geringer 15 ppm pro Kelvin. Zum Ansteuern der Schalter wird eine Quarzreferenz verwendet, die exzellente Temperaturdrifts von deutlich kleiner 1 ppm pro Kelvin hat. Den Hauptbeitrag liefert damit der Referenzkondensator 30, der einen typischen Temperaturdrift im Beispiel von 43 ppm pro Kelvin hat. Insgesamt bleibt jedoch selbst bei einer Worst-Case Abschätzung der gesamte Temperaturdrift der Anordnung deutlich unter 100 ppm pro Kelvin, was eine deutliche Verbesserung ist. Durch Verwendung der Kopie der Widerstandsserienschaltung 19' in der Serienschaltung 19 von Figur 9 werden jegliche Fehler vermieden, die durch Ladungsinjektion der Switched-Capacitor-Schaltkreise in den Nutzsignalpfad auftreten könnten.

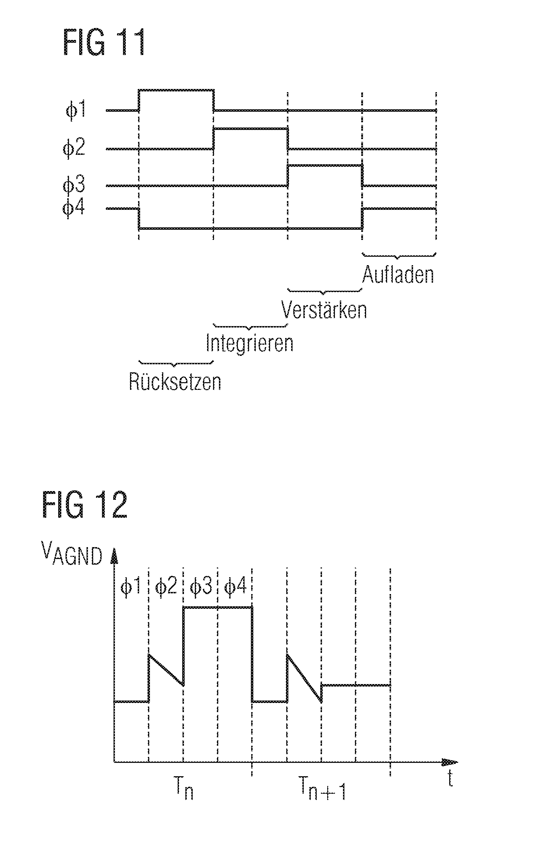

Figur 11 zeigt beispielhaft den Zeitverlauf der Steuersignale für die Schalter von Figur 10 in den vier vorgesehenen Taktphasen φ1 bis φ4. Dabei bedeutet die Bezeichnung der jeweiligen Schalter in Figur 10, dass dieser Schalter in der jeweiligen Taktphase betätigt, also geschlossen ist. Die erste Taktphase φ1 entspricht dabei einem Rücksetzen, die zweite einem Integrieren, die dritte einem Verstärken und die vierte einem Aufladen.

Im Detail werden in der ersten Taktphase φ1 bei der Schaltung die Kondensatoren 30, 36, 38 des Referenzwiderstands und des Rückführungszweigs des Fehlerverstärkers zurückgesetzt. Der Ausgang des Operationsverstärkers 27 wird auf die analoge Massespannung VAGND gesetzt. Am Ausgang des Verstärkers 44 bleibt die Steuerspannung unverändert.

In der zweiten Taktphase φ2 werden die Kondensatoren 36, 38 im Rückführungszweig des Fehlerverstärkers parallel geschaltet. Zu Beginn dieser Taktphase wird der Referenzwiderstand mit dem Kondensator 30 auf die analoge Bezugsspannung VAGND aufgeladen, diese Ladung wird auf die beiden Kondensatoren 36, 38 übertragen. Während der zweiten Taktphase werden die Kondensatoren 36, 38 entladen vom Ausgangsstrom IOUT in einem Integrationszyklus. Am Ende der zweiten Taktphase wird die Ladungsdifferenz zwischen der Bezugsspannung VAGND multipliziert mit dem Referenzkondensator 30 und der Ausgangsstrom Iout multipliziert mit der Taktdauer der zweiten Phase φ2 auf den Kondensatoren 36, 38 gespeichert.

In der dritten Taktphase φ3 wird die beschriebene Ladungsdifferenz verstärkt durch Übertragen der Ladung vom Kondensator 36 auf Kondensator 38. Hierfür ist Kondensator 36 auf die analoge Bezugsspannung VAGND kurzgeschlossen. Der Ausgang des Fehlerverstärkers 27 wird auf den geschalteten Kondensator 43 abgetastet.

In der vierten und letzten Taktphase φ4 wird die Ladung von dem Kondensator 43 in den Kondensator 45 des Schleifenfilters übertragen und stimmt das Gate des Transistors 21' und des Transistors 21 von Figuren 9 und 10 auf einen Wert ab. Dieser Wert legt zugleich den neuen Widerstandswert für den nachfolgenden Zyklus fest, den der Widerstand 21' und damit die Serienschaltung 19' hat.

Figur 12 zeigt den beispielhaften Verlauf des Bezugssignals als Fehlersignal VAGND, nämlich die Ladungsdifferenz. Wie anhand von Figur 12 erkennbar, ist im nachfolgenden Taktzyklus $T_{n+1}$ die Ladungsdifferenz kleiner aufgrund der Anpassung der Gate-Spannung Vctrl im vorangegangenen Zyklus $T_n$.

Bezugszeichenliste

| 1 | steuerbarer Widerstand |
|---|---|
| 1' | steuerbarer Widerstand |
| 2 | Referenzwiderstand |
| 3 | Vergleicher |
| 4 | Festwertwiderstand |
| 5 | Kondensator |
| 6 | Schalter |
| 7 | Verstärker |

| | |
|---|---|
| 8 | Nutzsignalquelle |
| 9 | Tiefpassfilter |
| 10 | Ausgang |
| 11 | gemeinsame Stromquelle |
| 12 | Umschalter |
| 13 | Signalpfad |
| 14 | Bezugspotentialanschluss |
| 15 | Bandpassfilter |
| 16 | Vergleicher |
| 17 | Switched-Capacitor |
| 18 | Transimpedanzverstärker |
| 19 | Serienschaltung |
| 20 | Festwertwiderstand |
| 21 | steuerbarer Widerstand |
| 20 | Fotodiode |
| 22 | Stromspiegel |
| 23 | Transistor |
| 24 | Verstärker |
| 25 | Bandgap |
| 26 | Schalter |
| 27 | Fehlerverstärker |
| 28 | Schalter |
| 29 | Switched-Capacitor |
| 30 | Kondensator |
| 31 | Schalter |
| 32 | Schalter |
| 33 | Schalter |
| 34 | Schalter |
| 35 | Schalter |
| 36 | Kondensator |
| 37 | Schalter |
| 38 | Kondensator |
| 39 | Schalter |
| 40 | Schalter |
| 41 | Schalter |
| 42 | Schalter |
| 43 | Switched-Capacitor |
| 44 | Verstärker |
| 45 | Kondensator |
| 46 | Kanal |
| 47 | Kanal |
| 48 | Kanal |
| 49 | Kondensator |
| 50 | Kondensator |
| 51 | Kondensator |
| 52 | Schalter |
| 53 | Schalter |
| 54 | Schalter |
| 55 | Schalter |
| 56 | Schalter |
| 57 | Schalter |

**Patentansprüche**

**1.** Anordnung zur Temperaturkompensation eines Widerstands

    - mit einem bezüglich des Widerstandswerts steuerbaren Widerstand (19'),

- mit einem Referenzwiderstand (29), der als Switched-Capacitor ausgebildet ist,
- mit einem Vergleicher (27), der eingangsseitig mit dem steuerbaren Widerstand (19') und dem Referenzwiderstand (29) gekoppelt ist und der einen Ausgang zum Abgeben eines Fehlersignals hat, und
- mit einem Steuereingang am steuerbaren Widerstand (19'), der mit dem Ausgang des Vergleichers (27) zum Steuern des Widerstandswerts gekoppelt ist, wobei
- ein weiterer steuerbarer Widerstand (19) mit steuerbarem Widerstandswert vorgesehen und in einem Nutzsignalpfad angeordnet ist, und wobei
- der Ausgang des Vergleichers (27) zusätzlich mit dem weiteren, steuerbaren Widerstand (19) gekoppelt ist zur Steuerung von dessen Widerstandswert.

2. Anordnung nach Anspruch 1,
   **dadurch gekennzeichnet, dass**
   der Vergleicher einen in Switched-Capacitor-Technik beschalteten Verstärker (27) als Fehlerverstärker umfasst.

3. Anordnung nach Anspruch 1 oder 2,
   **dadurch gekennzeichnet, dass**
   der steuerbare Widerstand (19') als Serienschaltung ausgebildet ist, die einen Festwert-Widerstand (20') und den steuerbaren Widerstand (21') umfasst.

4. Anordnung nach einem der Ansprüche 1 bis 3,
   **dadurch gekennzeichnet, dass**
   der als Switched-Capacitor ausgebildete Referenzwiderstand (29) eine Kapazität (30) und zumindest einen Schalter (33, 34) zum periodischen Umschalten in einem Referenztakt ($f_S$) umfasst.

5. Anordnung nach einem der Ansprüche 1 bis 4,
   **dadurch gekennzeichnet, dass**
   ein Referenztaktgenerator vorgesehen ist, der mit dem als Switched-Capacitor ausgebildeten Referenzwiderstand (29) gekoppelt ist.

6. Anordnung nach einem der Ansprüche 1 bis 5,
   **gekennzeichnet durch**
   deren Ausbildung in integrierter Schaltungstechnik.

7. Verfahren zur Temperaturkompensation eines Widerstands, mit folgenden Schritten:

   - Bereitstellen eines steuerbaren Widerstands (19'),
   - Bereitstellen und Ansteuern eines Referenzwiderstands (29) als Switched-Capacitor,
   - Vergleichen des Widerstandswerts des steuerbaren Widerstands (19') mit dem Widerstandswert des Referenzwiderstands (29),
   - Steuern des Widerstandswerts des steuerbaren Widerstands (19') in Abhängigkeit von einem Vergleichsergebnis des Vergleichs,
   - Bereitstellen eines weiteren, steuerbaren Widerstands (19) in einem Nutzsignalpfad und
   - Steuern des Widerstandswerts des weiteren, steuerbaren Widerstands (19) in Abhängigkeit von einem Vergleichsergebnis des Vergleichs.

8. Verfahren nach Anspruch 7,
   **gekennzeichnet durch**
   Vergleichen des Widerstandswerts des steuerbaren Widerstands (19') mit dem Widerstandswert des Referenzwiderstands (29) mit einem Switched-Capacitor-Fehlerverstärker (27).

9. Verfahren nach Anspruch 7 oder 8,
   **gekennzeichnet durch**
   Bereitstellen des Widerstandswerts des steuerbaren Widerstands (19') als Summe eines Festwert-Widerstandswerts (20') und eines steuerbaren Widerstandswerts (21').

10. Verfahren nach einem der Ansprüche 7 bis 9,
    **gekennzeichnet durch**
    Bereitstellen des Referenzwiderstands (29) **durch** periodisches Umschalten einer schaltbaren Kapazität (30) gesteuert von einem Referenztakt ($f_S$).

## FIG 1

$$R_{REF} = \frac{1}{C_S \cdot f_S}$$

## FIG 2

$$R_{REF} = \frac{1}{C_S \cdot f_S}$$

# FIG 3

# FIG 4A

# FIG 4B

FIG 5

FIG 6

## FIG 7

## FIG 8

## FIG 9

$V_{CTRL}$

21

$R_F$

$R_{TH}$

M1

20

19

$I_D$

20

18

$V_0 = I_D \cdot R_{TH}$

## FIG 10

40

M3  1:N  M4

C1  37  φ1-3

OP1

$V_{REF}$

M2

φ2

36

41  φ2

22

28  26

C2

39  φ1

24  23

φ1,3-4

38

35  φ2-4

42

25

29

27

$R_{TH}$  $I_{OUT}$

$C_R$

C4

20'

φ2  30  φ2  34

$R_P$

33  φ1

C3  φ4

45

31  φ1  32

OP2

43

44

$V_{CTRL}$

21'

φ3

φ4

φ3

22

M1

$I_{REF}(Z)$

OP3

19'

FIG 11

Rücksetzen

Integrieren

Verstärken

Aufladen

FIG 12

$V_{AGND}$

$\phi 1$  $\phi 2$  $\phi 3$  $\phi 4$

$T_n$  $T_{n+1}$

$t$

EP 2 051 372 A2

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Nicht-Patentliteratur

- **D. A. JOHNS ; K. MARTIN.** Analog Integrated Circuit Design. Wiley, 1997, 248-250

- **A. MCLAREN ; K. MARTIN.** Generation of Accurate On-Chip Time Constants And Stable Transconductances. *IEEE Journal of Solid-State Circuits,* April 2001, vol. 36 (4